# EUROPÄISCHE PATENTSCHRIFT

(11) **EP 3 176 555 B1**
(45) Veröffentlichungstag und Bekanntmachung des Hinweises auf die Patenterteilung: **30.09.2020**
(21) Anmeldenummer: 16200165.5
(22) Anmeldetag: 23.11.2016
(51) Int. Cl.: G01L 9/00, G01L 19/00, H01L 41/047

(54) **PIEZOELEKTRISCHER DRUCKSENSOR UND VERFAHREN ZUR HERSTELLUNG EINES SOLCHEN DRUCKSENSORS**
PIEZOELECTRIC PRESSURE SENSOR AND PROCESS OF MANUFACTURING THE SAME
CAPTEUR DE PRESSION PIEZOELECTRIQUE ET SON PROCÉDÉ DE FABRICATION

(30) Priorität: 03.12.2015 EP 15197864
(43) Veröffentlichungstag der Anmeldung: 07.06.2017
(73) Patentinhaber: Kistler Holding AG, 8408 Winterthur (CH)
(72) Erfinder: Brunner, Simon, 8307 Effretikon (CH); Haefner, Markus, 8050 Zuerich (CH)

(56) Entgegenhaltungen:
- WO-A1-2014/046048
- DE-A1-102007 024 445
- DE-A1-102009 039 827
- US-A1- 2004 007 075
- US-A1- 2015 325 777
- US-B1- 6 536 286

## Beschreibung

### Technisches Gebiet

Die Erfindung betrifft einen piezoelektrischen Drucksensor nach dem Oberbegriff des unabhängigen Anspruchs und ein Verfahren zur Herstellung eines solchen Drucksensors.

### Stand der Technik

Piezoelektrische Aufnehmer werden vielerorts in Sensoren verwendet zum Erfassen von Drücken, Kräften, Beschleunigungen, Dehnungen, Momenten, usw.. So wird mit piezoelektrischen Drucksensoren bei der Druckindizierung von Verbrennungsmotoren ein in einer Druckkammer herrschender Zylinderdruck in Abhängigkeit einer Kurbelwellenstellung oder einer Zeit erfasst. Verbrennungsmotoren umfassen Viertaktmotoren und Zweitaktmotoren wie Ottomotoren, Dieselmotoren, Wankelmotoren, usw.. Bei Schiffsdieselmotoren wird mit ihnen eine Langzeitüberwachung eines Zylinderdrucks durchgeführt. Piezoelektrische Drucksensoren lassen sich aber auch bei der Drucküberwachung in Strahltriebwerken, Gasturbinen, Dampfturbinen, Dampfmaschinen, usw.. einsetzen.

Zur Herstellung eines piezoelektrischen Aufnehmers wird oft piezoelektrisches Kristallmaterial verwendet. Das piezoelektrische Kristallmaterial wird kristallographisch so orientiert geschnitten, dass es eine hohe Empfindlichkeit für eine aufzunehmende Kraft hat. Unter der Wirkung der Kraft werden auf Oberflächen des piezoelektrischen Kristallmaterials elektrische Polarisationsladungen erzeugt. Die Anzahl der elektrischen Polarisationsladungen ist proportional zur Grösse der wirkenden Kraft.

Die Schrift CH392103A1 zeigt einen piezoelektrischen Drucksensor mit einer Membran, die mit einer Randpartie an einem Ende eines Gehäuses verschweisst ist. Membran und Gehäuse schützen den piezoelektrischen Aufnehmer im Einsatz vor übermässigen Temperaturspitzen. Der piezoelektrische Aufnehmer ist im Gehäuse hinter der Membran angeordnet. Eine von der Membran erfasste Kraft wirkt in Längsrichtung des piezoelektrischen Drucksensors auf den piezoelektrischen Aufnehmer. Dieser weist drei Stäbe aus piezoelektrischem Kristallmaterial, sowie Elektroden in Form einer Kontaktfeder und einer Rohrfeder auf. Die Elektroden sind aus elektrisch leitendem Material. Die Kontaktfeder ist auf einer Längsachse des piezoelektrischen Aufnehmers mittig zwischen den im Winkel von 120° zueinander stehenden Stäben angeordnet. Die Rohrfeder ist bezüglich der Längsachse aussenseitig an den Stäben angeordnet. Eine Normalkraft wirkt auf Stirnflächen der Stäbe und erzeugt auf transversal dazu stehenden Seitenflächen elektrische Polarisationsladungen, die von der Kontaktfeder als negative elektrische Ladungen und von der Rohrfeder als positive elektrische Ladungen abgenommen werden. Die Rohrfeder ist elektrisch und mechanisch mit dem Gehäuse verbunden und leitet die positiven elektrischen Ladungen an das Gehäuse ab. Kontaktfeder und Ladungsableitung sind einstückig, die Ladungsableitung erstreckt sich zentral auf der Längsachse von der Membran weg. Die Ladungsableitung ist elektrisch und mechanisch mit einer Buchse verbunden ist. Die Buchse ist an einem von der Membran abgewandten Ende des Gehäuses angeordnet und nimmt einen Stecker eines Kabels auf. Die Buchse ist elektrisch gegenüber dem Gehäuse isoliert. Von der Kontaktfeder abgenommene negative elektrische Ladungen werden somit über die Ladungsableitung zur Buchse und von der Buchse zum Kabel abgeleitet. Das Kabel wiederum ist elektrisch und mechanisch mit einer Auswerteeinheit verbunden, in der Auswerteeinheit werden die negativen elektrischen Ladungen elektrisch verstärkt und ausgewertet. Auch spannt die Rohrfeder die Stäbe aus piezoelektrischem Kristallmaterial derart mechanisch vor, dass Zug- und Druckkräfte erfasst werden können.

Nun ist der piezoelektrische Drucksensor beim dauerhaften Einsatz starken Motorvibrationen und hohen Temperaturen von 200°C und höher ausgesetzt. So kann es zu Mikroreibung und Reibkorrosion bei Kontaktoberflächen der Seitenflächen der Stäbe zur Kontaktfeder und zur Rohrfeder kommen, was die mechanische Stabilität der Ladungsableitung schwächen kann. Auch kann es bei hohen Temperaturen zur Diffusion von unedlen Metallen und zum lokalen Aufbau von Oxidschichten an den Kontaktoberflächen der Seitenflächen der Stäbe zur Kontaktfeder und zur Rohrfeder kommen. Diese Effekte können einzeln oder kombiniert auftreten. In der Folge kann sich der elektrische Widerstand bei der Ladungsableitung verändern. So kann der elektrische Kontaktwiderstand aus dem mΩ-Bereich um mehrere Grössenordnungen in den MΩ-Bereich ansteigen, was zu einer Verfälschung der Ladungsableitung und zu einer fehlerhaften Auswertung in der Auswerteeinheit führt.

DE102009039827A1 zeigt einen piezoelektrischen Drucksensor mit einem Elektrodenblech, welches mit einem Kontaktstift verbunden ist. Die Verbindung erfolgt durch Formschluss. Auch sind Messelemente durch Bonden mit dem Elektrodenblech verbunden. Das Elektrodenblech weist einen Elektrodenstreifen auf, der parallel zu einer Stirnfläche der Messelemente angeordnet ist.

DE10200702445A1 bezieht sich auf einen piezoelektrischen Drucksensor mit einer stoffschlüssigen Verbindung zwischen Messelementen und einer Ableitelektrode. In einer Ausführungsform für den Longitudinaleffekt ist die Ableitelektrode scheibenförmig und parallel zu Stirnflächen der Messelemente angeordnet.

WO2014046048A1 zeigt einen piezoelektrischen Drucksensor mit einem piezoelektrischen Element und einem Elektrodenelement, einem Verbinder und einem Elektrodenring. Der Verbinder drückt auf einer Seite über eine Feder auf das Elektrodenelement und ist auf einer anderen Seite mit dem Elektrodenringteil verbunden.

Eine erste Aufgabe der vorliegenden Erfindung besteht darin, einen piezoelektrischen Drucksensor anzugeben, bei dem die Ladungsableitung weitgehend unverfälscht ist. Eine weitere Aufgabe der vorliegenden Erfindung ist es, einen Drucksensor bereitzustellen, bei dem die Ladungsableitung auch bei dauerhaft starken Motorvibrationen mechanisch stabil angeordnet ist. Schliesslich soll der Drucksensor kostengünstig herstellbar sein.

### Darstellung der Erfindung

Zumindest eine dieser Aufgaben wird durch die Merkmale des unabhängigen Vorrichtungsanspruchs 1 und des unabhängigen Verfahrensanspruchs 7 gelöst.

Die Erfindung betrifft einen piezoelektrischen Drucksensor; mit einer Membran, welche eine Kraft erfasst; mit einem piezoelektrischen Aufnehmer, auf welchem die erfasste Kraft elektrische Polarisationsladungen erzeugt; mit einer Elektrode, welche erzeugte elektrische Polarisationsladungen abnimmt und über eine Ladungsableitung ableitet; wobei die Elektrode einen Ladungsabgriff und mindestens einen Elektrodenstreifen aufweist; wobei der Ladungsabgriff parallel zu einer Stirnfläche des piezoelektrischen Aufnehmers angeordnet ist, auf welche Stirnfläche die Kraft einwirkt; und wobei der Elektrodenstreifen bereichsweise stoffschlüssig mit der Ladungsableitung verbunden ist.

In Abkehr vom Stand der Technik nach der Schrift CH392103A1 erfolgt keine Anordnung des piezoelektrischen Aufnehmers um eine zentrale Kontaktfeder. Erfindungsgemäss erfolgt der Ladungsabgriff stirnflächig am piezoelektrischen Material. Dabei bleiben die Elektrode und das piezoelektrische Material unter der Wirkung der zu erfassenden Kraft und der mechanischen Vorspannung dauerhaft im vollflächigen elektrischen Kontakt, so dass auch bei starken Motorvibrationen kein Anstieg des elektrischen Kontaktwiderstandes erfolgen kann und keine Verfälschung der Ladungsableitung auftritt.

Die Erfindung betrifft auch ein Verfahren zur Herstellung eines solchen Drucksensors, wobei eine Antistrainhülse entlang einer Längsachse über den piezoelektrischen Aufnehmer geschoben wird und der Elektrodenstreifen schräg zur Längsachse durch eine Elektrodenöffnung der Antistrainhülse ragt.

Während im Stand der Technik nach der Schrift CH392103A1 der piezoelektrische Aufnehmer mit Seitenflächen um eine zentrale Kontaktfeder als Ladungsabgriff und Ladungsableitung angeordnet ist, erfolgt erfindungsgemäss ein Ladungsabgriff parallel zu einer Stirnfläche des piezoelektrischen Aufnehmers. Auch weist die Elektrode erfindungsgemäss einen Elektrodenstreifen auf, der stoffschlüssig mit einer Ladungsableitung verbunden ist. Der Elektrodenstreifen ragt schräg zur Längsachse durch eine Elektrodenöffnung einer Antistrainhülse. Dies hat den Vorteil, dass eine Kontaktfläche an einem äusseren Ende des Elektrodenstreifens von ausserhalb der Antistrainhülse zugänglich ist, was die Herstellung des Drucksensors rasch und weitgehend ausschussfrei und somit kostengünstig macht.

### Kurze Beschreibung der Zeichnungen

Im Folgenden wird die Erfindung unter Beizug der Figuren an einer beispielhaften Ausführungsform näher erklärt. Es zeigen
- Fig. 1: einen Längsschnitt durch einen Teil einer Aufnehmeranordnung eines Drucksensors, vor einer mechanischen Verbindung einer Membran und einer Antistrainhülse;
- Fig. 2: einen Längsschnitt durch einen Teil der Aufnehmeranordnung des Drucksensors nach Fig. 1, während der mechanischen Verbindung von Membran und Antistrainhülse;
- Fig. 3: einen Längsschnitt durch einen Teil der Aufnehmeranordnung des Drucksensors nach Fig. 2, nach der mechanischen Verbindung von Membran und Antistrainhülse;
- Fig. 4: eine perspektivische Ansicht der Aufnehmeranordnung des Drucksensors nach Fig. 3;
- Fig. 5: eine Ansicht einer Elektrode der Aufnehmeranordnung nach einer der Fig. 1 bis 4;
- Fig. 6: einen Längsschnitt durch einen Teil des Drucksensors vor einer stoffschlüssigen Verbindung einer Elektrode der Aufnehmeranordnung nach Fig. 3 oder 4 mit einer Ladungsableitung einer Ableitungsanordnung;
- Fig. 7: einen Längsschnitt durch einen Teil des Drucksensors nach Fig. 6 nach der stoffschlüssigen Verbindung der Elektrode der Aufnehmeranordnung mit der Ladungsableitung der Ableitungsanordnung;
- Fig. 8: einen Längsschnitt durch einen Teil eines Körpers des Drucksensors; und
- Fig. 9: einen Längsschnitt durch einen Teil des Drucksensors nach Fig. 7, nach der mechanischen Verbindung von Aufnehmeranordnung und Ableitungsanordnung mit dem Körper nach Fig. 8.

### Wege zur Ausführung der Erfindung

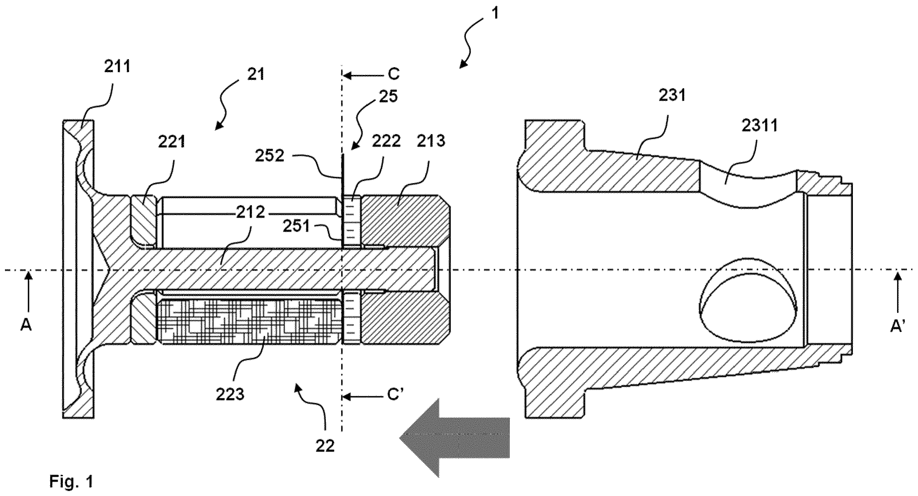

Fig. 1 bis 3 zeigen Schnitte durch einen Teil einer Aufnehmeranordnung 2 entlang einer Längsachse AA' eines Drucksensors 1. Die Aufnehmeranordnung 2 weist eine Membran 21 auf. Die Membran 21 besteht aus mechanisch nachgiebigen Materialen wie aus Reinmetallen, Nickellegierungen, Kobaltlegierungen, Eisenlegierungen, usw.. Die Membran 21 ist stempelförmig, mit einem radial von der Längsachse AA' beabstandeten Membranelement 211, einer sich auf der Längsachse AA' erstreckenden zentralen Vorspannelement 212 und einem Vorspannkörper 213. Das Membranelement 211 und das zentrale Vorspannelement 212 sind vorzugsweise einstückig. Ein bezüglich der Längsachse AA' vom Membranelement 211 abgewandtes Ende des zentralen Vorspannelementes 112 ist mechanisch mit dem Vorspannkörper 213 verbunden. Der Vorspannkörper 213 ist zylinderförmig. Die mechanischen Verbindung zwischen dem zentralen Vorspannelement 212 und dem Vorspannkörper 213 erfolgt durch Stoffschluss wie Schweissen, Diffusionsschweissen, Thermokompressionsbonden, Löten, usw.. Mit den mechanischen Verbindungen wird ein piezoelektrischer Aufnehmer 22 derart unter eine mechanische Vorspannung gesetzt, die in der Grössenordnung des Messbereichs des Drucksensors 1 liegt, dass die Bestandteile des Drucksensors 1 unverrückbar zueinander in Position gehalten werden.

Die Aufnehmeranordnung 2 weist eine hohlzylinderförmige Antistrainhülse 231 auf. Die Antistrainhülse 231 verhindert, dass mechanische Verspannungen sich von einer Befestigung des Drucksensors 1 auf Bauteile im Inneren des Drucksensors 1 übertragen. Die Antistrainhülse 231 besteht aus mechanisch nachgiebigen Materialen wie aus Reinmetallen, Nickellegierungen, Kobaltlegierungen, Eisenlegierungen, usw..

Die Aufnehmeranordnung 2 weist einen piezoelektrischen Aufnehmer 22 auf. Der piezoelektrische Aufnehmer 22 ist bezüglich der Längsachse AA' zwischen dem Membranelement 211 und dem Vorspannkörper 213 angeordnet. Der piezoelektrische Aufnehmer 22 wird vom zentralen Vorspannelement 212 der Membran 21 getragen. Der piezoelektrische Aufnehmer 22 weist ein Ausgleichelement 221, einen elektrische Isolationsring 222 und mindestens ein piezoelektrisches Aufnehmerelement 223 auf. Bezogen auf die Längsachse AA' ist das piezoelektrische Aufnehmerelement 223 zwischen dem Ausgleichelement 221 und dem elektrischen Isolationsring 222 angeordnet. Das Ausgleichelement 221 verteilt eine von der Membran 21 erfasste Normalkraft gleichmässig auf das piezoelektrische Aufnehmerelement 223. Die Normalkraft wirkt in Richtung der Längsachse AA'. Das Ausgleichelement 221 ist zylinderförmig und besteht aus elektrisch leitfähigem und mechanisch steifem Material wie aus Reinmetallen, Nickellegierungen, Kobaltlegierungen, Eisenlegierungen, elektrisch leitender Keramik, Keramik mit elektrisch leitender Beschichtung, usw.. Die Membran 21 ist im flächigen mechanischen Kontakt mit dem Ausgleichelement 221. Das Ausgleichelement 221 ist auch im flächigen mechanischen Kontakt mit dem piezoelektrischen Aufnehmerelement 223. Der flächige mechanische Kontakt zwischen dem Ausgleichelement 221 und dem piezoelektrischen Aufnehmerelement 223 kann auch durch mechanische Verbindung realisiert werden. Solch eine mechanische Verbindung kann durch Stoffschluss wie Diffusionsschweissen, Thermokompressionsbonden, Löten, usw. erfolgen. Bei Kenntnis der vorliegenden Erfindung kann der Fachmann den piezoelektrischen Aufnehmer auch ohne Ausgleichelement realisieren. Der elektrische Isolationsring 222 ist hohlzylinderförmig und besteht aus elektrisch isolierendem und mechanisch steifem Material wie Keramik, Al₂O₃-Keramik, Saphir, usw.. Der elektrische Isolationsring 222 isoliert eine Elektrode 25 elektrisch gegenüber dem Vorspannkörper 213.

Das piezoelektrische Aufnehmerelement 223 ist zylinderförmig und besteht aus piezoelektrischem Material wie Quarz (SiO₂ Einkristall), Calcium-Gallo-Germanat (Ca₃Ga₂Ge₄O₁₄ oder CGG), Langasit (La₃Ga₅SiO₁₄ oder LGS), Turmalin, Galliumorthophosphat, Piezokeramik, usw.. Das piezoelektrische Aufnehmerelement 223 ist kristallographisch so orientiert geschnitten, dass es eine hohe Empfindlichkeit für die aufzunehmende Kraft hat. Vorzugsweise ist das piezoelektrisches Material für den Normaleffekt so orientiert in Scheiben geschnitten, dass auf den gleichen Oberflächen auf denen eine Normalkraft einwirkt, auch elektrische Polarisationsladungen erzeugt werden. Vorzugsweise ist das piezoelektrische Material für den Transversaleffekt so orientiert in Stäbe geschnitten, dass elektrische Polarisationsladungen auf transversal zur Normalkraft stehen Oberflächen erzeugt werden.

In der dargestellten Ausführungsform der Erfindung ist das piezoelektrische Material für den Transversaleffekt in drei stabförmige piezoelektrische Aufnehmerelement 223 geschnitten. Die piezoelektrischen Aufnehmerelemente 223 sind im Winkel von 120° zueinander angeordnet. Die piezoelektrischen Aufnehmerelemente 223 sind äquidistant zur Längsachse AA' angeordnet. Die Normalkraft wirkt über Stirnflächen der piezoelektrischen Aufnehmerelemente 223 auf das piezoelektrische Material ein und erzeugt auf Seitenflächen der piezoelektrischen Aufnehmerelemente 223 elektrische Polarisationsladungen. Pro piezoelektrisches Aufnehmerelement 223 werden auf der der Längsachse AA' zugewandten Seitenfläche negative elektrische Ladungen erzeugt und auf der von der Längsachse AA' abgewandten Seitenfläche werden positive elektrische Ladungen erzeugt. Die piezoelektrischen Aufnehmerelemente 223 sind metallisiert. Die Metallisierungen sind elektrisch leitend. Pro piezoelektrisches Aufnehmerelement 223 reicht eine erste Metallisierung von der der Längsachse AA' zugewandten Seitenfläche auf die der Membran 21 abgewandten Stirnfläche und eine zweite Metallisierung reicht von der der Längsachse AA' abgewandten Seitenfläche auf die der Membran 21 zugewandte Stirnfläche. Die erste und zweite Metallisierung sind elektrisch voneinander isoliert. Pro piezoelektrisches Aufnehmerelement 223 leitet die erste Metallisierung negative elektrische Ladungen auf die der Membran 21 abgewandte Stirnfläche ab und die zweite Metallisierung leitet positive elektrische Ladungen auf die der Membran 21 zugewandte Stirnfläche ab. Bei Kenntnis der vorliegenden Erfindung kann der Fachmann diese Ladungsableitung natürlich auch umkehren und pro piezoelektrisches Aufnehmerelement die positive elektrische Ladungen auf die der Membran abgewandte Stirnfläche ableiten und negative elektrische Ladungen auf die der Membran zugewandte Stirnfläche ableiten. Auch kann der Fachmann die Erfindung mit piezoelektrischem Kristallmaterial realisieren, das für den Normaleffekt in scheibenförmiges piezoelektrisches Aufnehmerelement geschnitten ist. Die über Stirnflächen des piezoelektrischen Aufnehmerelements 223 auf das piezoelektrische Material einwirkende Normalkraft erzeugt auf diesen Stirnflächen elektrische Polarisationsladungen. Beispielsweise werden auf der der Membran abgewandten Stirnfläche negative elektrische Ladungen erzeugt und auf der der Membran zugewandten Stirnfläche werden positive elektrische Ladungen erzeugt.

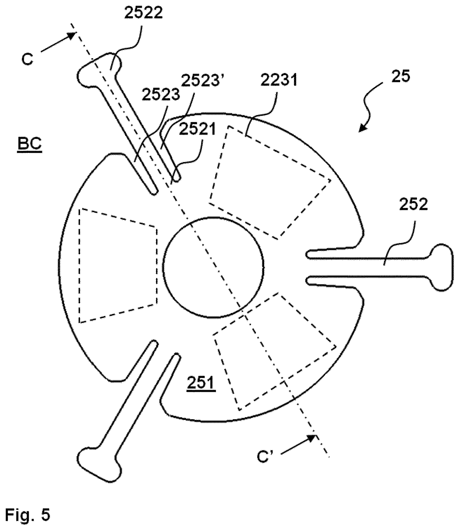

Die Aufnehmeranordnung 2 weist eine Elektrode 25 auf. Die Elektrode 25 besteht aus elektrisch leitfähigem Material wie aus Reinmetallen, Nickellegierungen, Kobaltlegierungen, Eisenlegierungen, usw.. Die Elektrode 25 ist folienartig. Die Elektrode 25 weist eine Dicke von kleiner/gleich 200pm, vorzugsweise kleiner/gleich 20pm auf. Fig. 5 zeigt eine Ansicht der Elektrode 25. Die Elektrode 25 ist weitgehend in einer Elektrodenebene BC angeordnet und weist einen hohlzylinderförmigen Ladungsabgriff 251 und mindestens einen länglichen Elektrodenstreifen 252 auf. Die Elektrodenebene BC steht schräg zur Längsachse AA' und ist parallel zu den der Membran 21 abgewandten Stirnflächen 2231 der piezoelektrischen Aufnehmerelemente 223. Aufgrund der geringen Dicke der Elektrode 25 weist das Elektrodenmaterial unter der Wirkung der Normalkraft auch eine geringe Längenänderung entlang der Längsachse AA' auf (Hookesche Gesetz). Die geringe Längenänderung minimiert den Fehlerbeitrag des Elektrodenmaterials bei der Krafterfassung. Um dies zu veranschaulichen sind in Fig. 5 die drei Stirnflächen 2231 der drei piezoelektrischen Aufnehmerelemente 223 gestrichelt eingezeichnet. Vorzugsweise bedeckt der Ladungsabgriff 251 die Stirnflächen 2231 vollständig. Vorzugsweise drei Elektrodenstreifen 252 sind im Winkel von 120° zueinander angeordnet. Drei Elektrodenstreifen 252 ermöglichen eine redundante Ladungsableitung. Dies hat den Vorteil, dass bei Ausfall eines Elektrodenstreifens 252 oder zweier Elektrodenstreifen 252, wie durch Bruch, Riss, usw., mindestens ein verbleibender Elektrodenstreifen 252 eine Ladungsableitung sichergestellt. Die Elektrode 25 ist spiegelsymmetrisch bezüglich einer Symmetrieachse CC' der Elektrode 25. Die Symmetrieachse CC' liegt in der Elektrodenebene BC. Der Ladungsabgriff 251 ist zentral angeordnet. Ein Durchmesser einer zentralen Öffnung des Ladungsabgriffs 251 ist derart grösser als ein Aussendurchmesser des zentralen Vorspannelementes 212, dass die Elektrode 25 um das zentrale Vorspannelement 212 angeordnet werden kann, ohne einen mechanischen und elektrischen Kontakt mit dem zentralen Vorspannelement 212 zu bilden. Der Elektrodenstreifen 252 erstreckt sich radial vom Ladungsabgriff weg. Der Elektrodenstreifen 252 weist zwei Enden 2521, 2522 auf. An einem inneren Ende 2521 ist der Elektrodenstreifen 252 einstückig mit dem Ladungsabgriff 251 verbunden. An einem äusseren Ende 2522 weist der Elektrodenstreifen 252 eine Kontaktfläche auf. Vorzugsweise befinden sich die inneren Enden 2521 von drei Elektrodenstreifen 252 im gleichen radialen Abstand zur zentralen Öffnung. Vorzugsweise liegen die inneren Enden 2521 der drei Elektrodenstreifen 252 im radialen Abstand weitgehend mittig zwischen dem Durchmesser der Öffnung und einem Aussendurchmesser des Ladungsabgriffs 251. Vorzugsweise ist der Elektrodenstreifen 252 bereichsweise durch zwei Nuten 2523, 2523' vom Ladungsabgriff 251 beabstandet. Die Nuten 2523, 2523' reichen vom inneren Ende 2521 des Elektrodenstreifens 252 bis zum Aussendurchmesser des Ladungsabgriffs 251. Der Elektrodenstreifen 252 ist aus der Elektrodenebene BC gegenüber dem Ladungsabgriff 251 auslenkbar. Die Auslenkung ist reversibel. Bei der Auslenkung wird das Material der Elektrode 25 elastisch verformt, eine plastische Verformung des Materials der Elektrode 25 wird vermieden. Über Parameter wie die Dicke der Elektrode 25, die Länge des Elektrodenstreifens 252, die Länge der Nuten 2523, 2523', usw. wird ein zulässiger Bereich der Auslenkung eingestellt, in welchem Bereich der Auslenkung keine plastische Verformung des Materials der Elektrode 25 erfolgt. Eine Auslenkung im zulässigen Bereich wird durch einen Biegeradius r des Elektrodenstreifens 252 definiert. Bei Kenntnis der vorliegenden Erfindung kann der Fachmann die Elektrode auch mit einer anderen Anzahl Elektrodenstreifen realisieren.

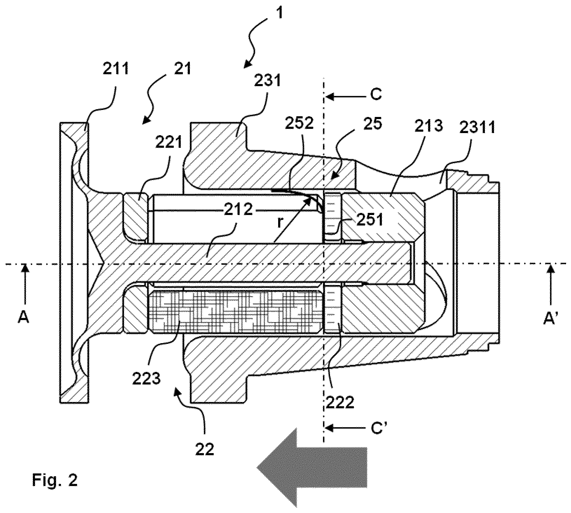

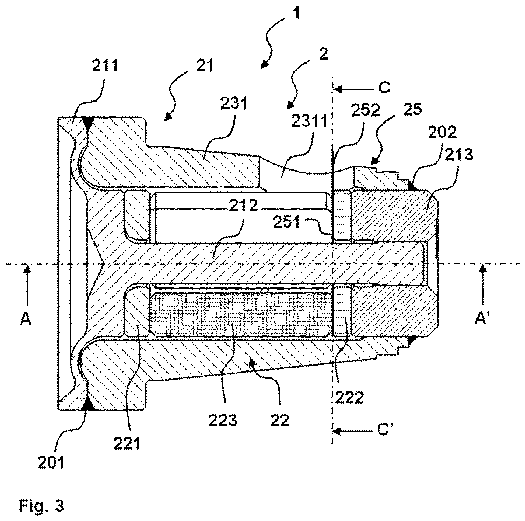

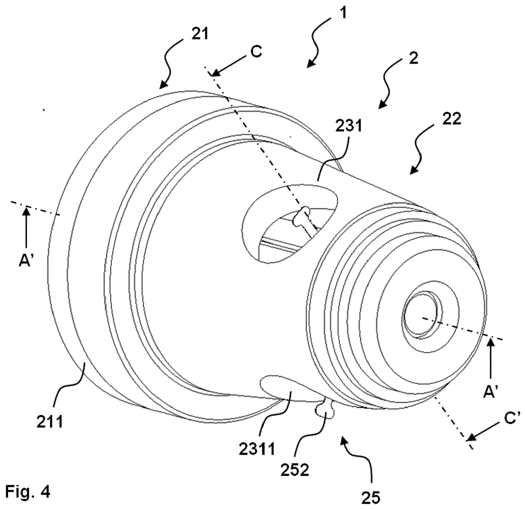

Die Fig. 1 bis 3 zeigen Verfahrensschritte der mechanischen Verbindungen der Membran 21 mit der Antistrainhülse 231. Wie in Fig. 1 und 2 durch einen Pfeil schematisch dargestellt, wird die Antistrainhülse 231 entlang der Längsachse AA' über die Membran 21 geschoben. In Fig. 1 sind Membran 21 und Antistrainhülse 231 zueinander beabstandet. Der mindestens eine Elektrodenstreifen 252 liegt in der schräg zur Längsachse AA' stehenden Elektrodenebene BC. In Fig. 2 ist die Antistrainhülse 231 teilweise über die Membran 21 geschoben, dabei wird der Elektrodenstreifen 252 von einer Wandung der Antistrainhülse 231 derart gegen das piezoelektrische Aufnehmerelement 223 ausgelenkt, dass der Elektrodenstreifen 252 teilweise parallel zur Längsachse AA' liegt. Der Biegeradius r ist parabelförmig. Eine Grösse des Biegeradius r entspricht weitgehend einer länglichen Ausdehnung der Stirnfläche 2231 der piezoelektrischen Aufnehmerelemente 223 entlang der Symmetrieachse CC'. In Fig. 3 ist die Antistrainhülse 231 vollständig über die Membran 21 geschoben. Der Elektrodenstreifen 252 wird nicht mehr von der Wandung der Antistrainhülse 231 ausgelenkt. Wie in der perspektivischen Ansicht nach Fig. 4 dargestellt, ragt der Elektrodenstreifen 252 durch eine Elektrodenöffnung 2311 der Antistrainhülse 231. Der Elektrodenstreifen 252 hat sich wieder weitgehend in die Elektrodenebene BC eingelenkt. Die Kontaktfläche des Elektrodenstreifens 252 ist somit von ausserhalb der Antistrainhülse 231 und somit auch von ausserhalb der Aufnehmeranordnung 2 zugänglich.

Das Membranelement 211 wird mechanisch mit einem ersten Ende der Antistrainhülse 231 verbunden. Der Vorspannkörper 213 wird mechanisch mit einem zweiten Ende der Antistrainhülse 231 verbunden. Die mechanischen Verbindungen zwischen Membranelement 211 und Antistrainhülse 231 sowie zwischen Vorspannkörper 213 und Antistrainhülse 231 erfolgen vorzugsweise durch Stoffschluss wie Schweissen, Diffusionsschweissen, Thermokompressionsbonden, Löten, usw.. In Fig. 3 ist eine erste Aufnehmeranordnungverbindung 201 des Membranelementes 211 mit dem ersten Ende der Antistrainhülse 231 eingezeichnet, und in Fig. 3 ist eine zweite Aufnehmeranordnungverbindung 202 des Vorspannkörpers 213 mit dem zweiten Ende der Antistrainhülse 231 eingezeichnet. Die so hergestellte Aufnehmeranordnung 2 ist eine Baugruppe.

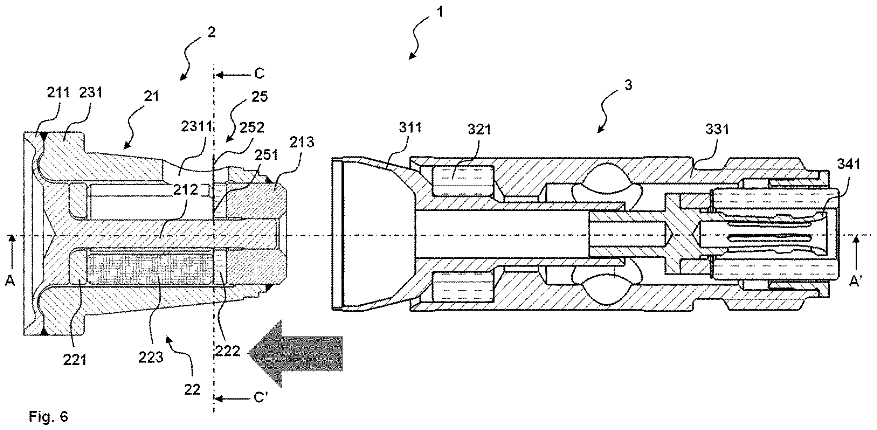

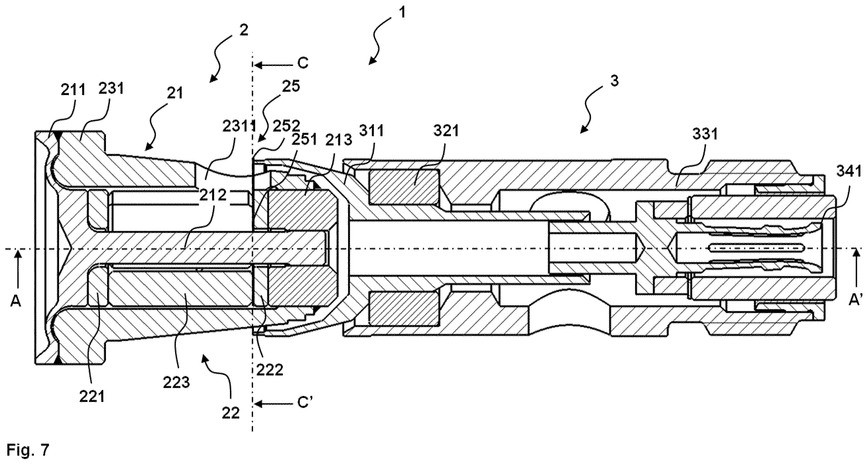

Fig. 6 und 7 zeigen Verfahrensschritte der stoffschlüssigen Verbindung der Elektrode 25 mit einer Ladungsableitung 311 einer Ableitungsanordnung 3 des Drucksensors 1. Auch die Ableitungsanordnung 3 ist eine Baugruppe. Die Ableitungsanordnung 3 weist die Ladungsableitung 311, eine elektrische Steckverbindung 341 und ein Ableitungskörper 331 auf. Ladungsableitung 311 und elektrische Steckverbindung 341 sind im Ableitungskörper 331 angeordnet. Der Ableitungskörper 331 hält die Bestandteile der Ableitungsanordnung 3 in unverrückbarer Position zueinander. Der Ableitungskörper 331 ist hohlzylinderförmig und besteht aus mechanisch beständigem Material wie aus Reinmetallen, Nickellegierungen, Kobaltlegierungen, Eisenlegierungen, usw.. Die Ladungsableitung 311 ist über ein elektrisches Isolationselement 321 elektrisch gegenüber dem Ableitungskörper 331 isoliert. Das elektrische Isolationselement 321 ist zylinderförmig und besteht aus elektrisch isolierendem und mechanisch steifem Material wie Keramik, Al₂O₃-Keramik, Saphir, usw..

Die Ladungsableitung 311 ist hohlzylinderförmig und besteht aus elektrisch leitfähigem Material wie aus Reinmetallen, Nickellegierungen, Kobaltlegierungen, Eisenlegierungen, usw.. Die Ladungsableitung 311 leitet die von der Elektrode 25 abgegriffenen elektrischen Polarisationsladungen an die elektrische Steckverbindung 341 ab. Ladungsableitung 311 und elektrische Steckverbindung 341 sind elektrisch und mechanisch miteinander verbunden. Vorzugsweise sind Ladungsableitung 311 und elektrische Steckverbindung 341 bereichsweise durch Stoffschluss wie Schweissen, Diffusionsschweissen, Thermokompressionsbonden, Löten, usw.. miteinander verbunden. In Fig. 6 und 7 weist der Ableitungskörper 331 mindestens eine Öffnung auf, durch welche Öffnung ein Fügewerkzeug Zugang zu dem Verbindungsbereich hat und den Stoffschluss herstellt.

In Fig. 6, 7 und 9 ist nur ein weiblicher Teil der elektrischen Steckverbindung 341 dargestellt. Der weibliche Teil der elektrischen Steckverbindung 341 ist als Buchse ausgeführt. Die Buchse ist mit einem entsprechend geformten männlichen Teil der elektrischen Steckverbindung oder Stecker formschlüssig und elektrisch verbindbar. Elektrische Polarisationsladungen werden über die elektrische Steckverbindung zu einer Auswerteeinheit abgeleitet. Stecker, Kabel und Auswerteeinheit sind in den Figuren nicht dargestellt. In der Auswerteinheit werden die elektrischen Polarisationsladungen elektrisch verstärkt und ausgewertet. Bei Kenntnis der vorliegenden Erfindung kann der Fachmann die elektrische Steckverbindung anstelle einer Buchse auch als Einbaustecker realisieren, der mit einer entsprechend geformten Kupplung formschlüssig und elektrisch verbindbar ist und elektrische Polarisationsladungen zu einer Auswerteeinheit ableitet.

Aufnehmeranordnung 2 und Ableitungsanordnung 3 sind Baugruppen. Dies hat den Vorteil, dass Varianten der Aufnehmeranordnung 2 mit Varianten der Ableitungsanordnung 3 zu einem Drucksensor 1 herstellbar sind, was eine Anzahl der Gleichteile erhöht und die Herstellung kostengünstig macht. Varianten der Aufnehmeranordnung 2 umfassen, Membrane 21 mit verschiedenen Membranstärken, piezoelektrische Aufnehmerelemente 223 nach dem Transversaleffekt oder dem Normaleffekt, piezoelektrische Aufnehmer 22 mit unterschiedlicher Empfindlichkeit, piezoelektrische Aufnehmer 22 für unterschiedliche Einsatztemperaturbereiche, usw.. Varianten der Ableitungsanordnung 3 umfassen unterschiedliche Arten der elektrischen Steckverbindung 341, elektrische Steckverbindungen 341 mit verschieden langen Kabeln, usw..

In Fig. 6 sind Ableitungsanordnung 3 und Aufnehmeranordnung 2 zueinander beabstandet. Wie durch einen Pfeil schematisch dargestellt, werden die Ableitungsanordnung 3 und die Aufnehmeranordnung 2 zueinander positioniert. Vorzugsweise erfolgt diese Positionierung durch Verschieben der Ableitungsanordnung 3 gegen die Aufnehmeranordnung 2. In Fig. 7 ist die Ableitungsanordnung 3 derart an der Aufnehmeranordnung 2 positioniert, dass die Ladungsableitung 311 mindestens einen aus der Elektrodenöffnung 2311 ragenden Elektrodenstreifen 252 mechanisch kontaktiert. Solange der Elektrodenstreifen 252 nicht mit der Ladungsableitung 311 stoffschlüssig verbunden ist, ist der Elektrodenstreifen 252 aus der Elektrodenebene BC reversibel auslenkbar. Sobald der Elektrodenstreifen 252 mit der Ladungsableitung 311 stoffschlüssig verbunden ist, ist der Elektrodenstreifen 252 nicht mehr aus der Elektrodenebene BC reversibel auslenkbar. Die Ladungsableitung 311 wird in der Kontaktposition mit dem Elektrodenstreifen 252 bereichsweise stoffschlüssig verbunden. Der Stoffschluss erfolgt durch Schweissen, Diffusionsschweissen, Thermokompressionsbonden, Löten, usw.. Vorzugsweise werden die Ladungsableitung 311 und der Elektrodenstreifen 252 in dieser Kontaktposition mechanisch fixiert und die Kontaktfläche des Elektrodenstreifens 252 wird von einem Fügewerkzeug gegen ein der Membran 21 zugewandtes Ende der Ladungsableitung 311 gedrückt und verschweisst.

Vorzugsweise ist der Elektrodenstreifen 252 mechanisch weitgehend spannungsfrei mit der Ladungsableitung 311 verbunden. Der Elektrodenstreifen 252 ist somit mechanisch weitgehend entspannt in der Elektrodenöffnung 2311 angeordnet. Aufgrund der geringen Dicke der Elektrode 25 und der weitgehend spannungsfreien mechanischen Anordnung des Elektrodenstreifens 252 ist auch ein Kraftnebenschluss entsprechend gering, mit welchem ein Teil der Normalkraft über die Elektrode 25 in die Ladungsableitung 311 fliessen kann. Der geringe Kraftnebenschluss minimiert den Fehlerbeitrag der Ladungsableitung bei der Krafterfassung. Auch erfolgt mit der spannungsfreien stoffschlüssigen Verbindung des Elektrodenstreifens 252 mit der Ladungsableitung 311 eine Temperaturausdehnungsentkoppelung. Gerade bei hohen Temperaturen können sich die Materialien der Aufnehmeranordnung 2, Ableitungsanordnung 3 und des Körpers 4 unterschiedlich ausdehnen, welche Ausdehnung sich nicht als störende mechanische Spannungen auf das piezoelektrische Aufnehmerelement 223 auswirken können, wodurch das piezoelektrische Aufnehmerelement 223 somit entkoppelt ist. Beispielsweise ändert sich bei hohen Temperaturen eine Länge der Aufnehmeranordnung 2 entlang der Längsachse AA' relativ zu einer Länge der Ableitungsanordnung 3 um eine kleine Ausdehnung von 0.05mm. Nach Fig. 7 liegt dann ein von der Membran 21 abgewandtes Ende der Aufnehmeranordnung 2 um 0.05mm näher an einem der Membran 21 zugewandten Ende der Ableitungsanordnung 3. Während sich bei Raumtemperatur der Elektrodenstreifen 252 in einem rechten Winkel zur Längsachse AA' von der Ladungsableitung 311 zum Ladungsabgriff 251 erstreckt, ist der Ladungsabgriff 251 bei hohen Temperaturen durch die relative Längenänderung um 0.05mm gegen die Ableitungsanordnung 3 verschoben und der Elektrodenstreifen 252 erstreckt sich dann in einem nicht mehr rechten Winkel zur Längsachse AA' von der Ladungsableitung 311 zum Ladungsabgriff 251.

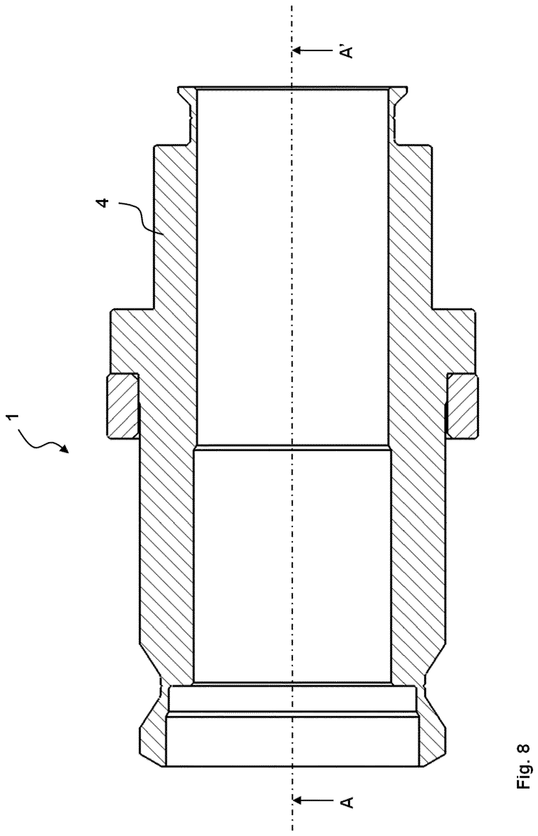

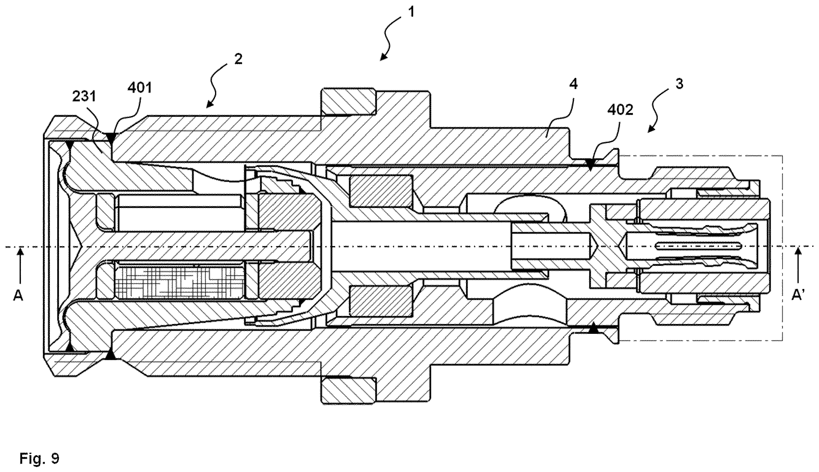

Fig. 8 zeigt einen Körper 4 des Drucksensors 1. Der Körper 4 schützt die Bestandteile des druck- und Kraftsensors 1 vor Stössen, Schlägen, Staub, Feuchtigkeit, usw., die im Einsatz auftreten. Der Körper 4 ist hohlzylinderförmig und besteht aus mechanisch beständigem Material wie aus Reinmetallen, Nickellegierungen, Kobaltlegierungen, Eisenlegierungen, usw.. Ein Innendurchmesser des Körpers 4 ist derart grösser/gleich einem Aussendurchmesser der Ableitungsanordnung 3, dass der Körper 4 entlang der Längsachse AA' über die Ableitungsanordnung 3 schiebbar ist. Wie in Fig. 9 dargestellt, wird der Körper 4 entlang der Längsachse AA' über die Ableitungsanordnung 3, bis ein erstes Ende des Körpers 4 einen Absatz der Antistrainhülse 231 der Aufnehmeranordnung 2 mechanisch kontaktiert. In dieser Kontaktposition werden die Aufnehmeranordnung 2 mit dem Körper 4 und die Ableitungsanordnung 3 mit dem Körper 4 bereichsweise durch Stoffschluss wie Schweissen, Diffusionsschweissen, Thermokompressionsbonden, Löten, usw.. verbunden. In Fig. 9 ist eine erste Körperverbindung 401 der Antistrainhülse 231 mit dem ersten Ende des Körpers 4 eingezeichnet, und in Fig. 9 ist eine zweite Körperverbindung 402 des Ableitungskörpers 331 mit einem zweiten Ende des Körpers 4 eingezeichnet. Die Ableitungsanordnung 3 und die Aufnehmeranordnung 2 sind in der Kontaktposition derart im Körper 4 angeordnet, dass die stoffschlüssige Verbindung zwischen Elektrodenstreifen 252 und Ladungsableitung 311 die einzige direkte mechanische und elektrische Verbindung zwischen Ableitungsanordnung 3 und Aufnehmeranordnung 2 ist.

### Bezugszeichenliste

- AA': Längsachse
- BC: Elektrodenebene
- CC': Symmetrieachse
- r: Biegeradius
- 1: Drucksensor
- 2: Aufnehmeranordnung
- 3: Ableitungsanordnung
- 4: Körper
- 21: Membran
- 201, 202: Aufnehmeranordnungverbindung
- 211: Membranelement
- 212: zentrales Vorspannelement
- 213: Vorspannkörper
- 22: piezoelektrischer Aufnehmer
- 221: Ausgleichelement
- 222: elektrischer Isolationsring
- 223: piezoelektrisches Aufnehmerelement
- 2231: Stirnfläche
- 231: Antistrainhülse
- 2311: Elektrodenöffnung
- 25: Elektrode
- 251: Ladungsabgriff
- 252: Elektrodenstreifen
- 2512: inneres Ende
- 2522: äusseres Ende
- 2523, 2523': Nut
- 311: Ladungsableitung
- 321: elektrisches Isolationselement
- 331: Ableitungskörper
- 341: elektrische Steckverbindung
- 401, 402: Körperverbindung

## Patentansprüche

1. Piezoelektrischer Drucksensor (1); mit einem Körper (4), welcher die Bestandteile des Drucksensors (1) vor Stössen, Schlägen, Staub, Feuchtigkeit schützt; mit einer Membran (21), welche eine Kraft erfasst; mit einem piezoelektrischen Aufnehmer (22), auf welchem die erfasste Kraft elektrische Polarisationsladungen erzeugt; mit einer Elektrode (25), welche erzeugte elektrische Polarisationsladungen abnimmt und über eine Ladungsableitung (311) einer Ableitungsanordnung (3) ableitet; welche Elektrode (25) einen Ladungsabgriff (251) und mindestens einen Elektrodenstreifen (252) aufweist; welcher Ladungsabgriff (251) parallel zu einer Stirnfläche (2231) des piezoelektrischen Aufnehmers (22) angeordnet ist, auf welche Stirnfläche (2231) die Kraft einwirkt; **dadurch gekennzeichnet, dass** der Drucksensor (1) eine Antistrainhülse (231) aufweist, welche verhindert, dass mechanische Verspannungen sich von einer Befestigung des Drucksensors (1) auf Bauteile im Inneren des Drucksensors (1) übertragen; dass die Antistrainhülse (231) mechanisch mit der Membran (21) verbunden ist; dass der Elektrodenstreifen (252) durch eine Elektrodenöffnung (2311) der Antistrainhülse (231) ragt; dass ein Innendurchmesser des Körpers (4) derart grösser/gleich einem Aussendruchmesser der Ableitungsanordnung (3) ist, dass der Körper (4) entlang einer Längsachse (AA') über die Ableitungsanordnung (3) in eine Kontaktposition schiebbar ist, dass in dieser Kontaktposition der Körper (4) mit der Antistrainhülse (231) mechanisch verbunden ist, und dass in dieser Kontaktposition der Körper (4) mit der Ableitungsanordnung (3) mechanisch verbunden ist; und dass der Elektrodenstreifen (252) bereichsweise stoffschlüssig mit der Ladungsableitung (311) verbunden ist; und dass die stoffschlüssige Verbindung zwischen den Elektrodenstreifen (252) und der Ladungsableitung (311) die einzige direkte mechanische und elektrische Verbindung zwischen der Ableitungsanordnung (3) und der Aufnehmeranordnung (2) ist, wobei die Aufnehmeranordnung (2) die Membrane (21), den piezoelektrischen Aufnehmer (22) und die Antistrainhülse (231) aufweist.

2. Piezoelektrischer Drucksensor (1) nach Anspruch 1, **dadurch gekennzeichnet, dass** der Ladungsabgriff (251) und der Elektrodenstreifen (252) weitgehend in einer Elektrodenebene (BC) angeordnet sind, welche Elektrodenebene (BC) parallel zur Stirnfläche (2231) des piezoelektrischen Aufnehmers (22) ist.

3. Piezoelektrischer Drucksensor (1) nach einem der Ansprüche 1 oder 2, **dadurch gekennzeichnet, dass** die Elektrode (25) folienartig ist; und dass die Elektrode (25) eine Dicke von kleiner/gleich 200pm, vorzugsweise kleiner/gleich 20pm aufweist.

4. Piezoelektrischer Drucksensor (1) nach einem der Ansprüche 1 bis 3, **dadurch gekennzeichnet, dass** der Elektrodenstreifen (251) mechanisch weitgehend spannungsfrei mit der Ladungsableitung (311) verbunden ist.

5. Piezoelektrischer Drucksensor (1) nach Anspruch 1, **dadurch gekennzeichnet, dass** der Elektrodenstreifen 252 an einem äusseren Ende (2522) eine Kontaktfläche aufweist; und dass die Kontaktfläche des Elektrodenstreifens (252) von ausserhalb der Antistrainhülse (231) zugänglich ist.

6. Piezoelektrischer Drucksensor (1) nach einem der Ansprüche 1 bis 5, **dadurch gekennzeichnet, dass** mehrere Elektrodenstreifen (251) mit der Ladungsableitung (311) stoffschlüssig verbunden sind und elektrische Polarisationsladungen redundant zur Ladungsableitung (311) ableiten.

7. Verfahren zur Herstellung eines piezoelektrischen Drucksensors (1) nach einem der Ansprüche 1 bis 6, **dadurch gekennzeichnet, dass** die Antistrainhülse (231) entlang einer Längsachse (AA') über den piezoelektrischen Aufnehmer (22) geschoben wird und der Elektrodenstreifen (252) schräg zur Längsachse (AA') durch eine Elektrodenöffnung (2311) der Antistrainhülse (231) ragt.

8. Verfahren nach Anspruch 7, **dadurch gekennzeichnet, dass** der Elektrodenstreifen (252) beim Überschieben der Antistrainhülse (231) von einer Wandung der Antistrainhülse (231) aus einer Elektrodenebene (BC) ausgelenkt wird; und dass der Elektrodenstreifen (252) nach dem Überschieben der Antistrainhülse (231) durch die Elektrodenöffnung (2311) der Antistrainhülse (231) ragt und sich wieder weitgehend in die Elektrodenebene (BC) einlenkt.

9. Verfahren nach einem der Ansprüche 7 oder 8, **dadurch gekennzeichnet, dass** die Membran (21) ein Membranelement (211), ein zentrales Vorspannelement (212) und einen Vorspannkörper (213) aufweist, ein vom Membranelement (211) abgewandtes Ende des zentralen Vorspannelementes (212) wird mechanisch mit dem Vorspannkörper (213) verbunden; dass der piezoelektrische Aufnehmer (22) bezüglich der Längsachse (AA') zwischen dem Membranelement (211) und dem Vorspannkörper (213) angeordnet wird; dass der piezoelektrische Aufnehmer (22) vom zentralen Vorspannelement (212) getragen wird; dass ein erstes Ende der Antistrainhülse (231) mit dem Membranelement (211) mechanisch verbunden wird; und dass ein zweites Ende der Antistrainhülse (231) mit dem Vorspannkörper (213) mechanisch verbunden wird, wodurch eine Aufnehmeranordnung (2) gebildet wird.

10. Verfahren nach Anspruch 9, **dadurch gekennzeichnet, dass** die Ladungsableitung (311) und eine elektrische Steckverbindung (341) elektrisch und mechanisch miteinander verbunden werden; dass die Ladungsableitung (311) und die elektrische Steckverbindung (341) in einem Ableitungskörper (331) angeordnet werden und die Ladungsableitung (311) elektrische Polarisationsladungen an die elektrische Steckverbindung (341) ableitet, wodurch eine Ableitungsanordnung (3) gebildet wird.

11. Verfahren nach Anspruch 10, **dadurch gekennzeichnet, dass** die Ableitungsanordnung (3) und die Aufnehmeranordnung (2) derart zueinander in einer Kontaktposition positioniert werden, dass die Ladungsableitung (311) den aus der Elektrodenöffnung (2311) ragenden Elektrodenstreifen (252) mechanisch kontaktiert; und dass der Elektrodenstreifen (252) und die Ladungsableitung (311) in dieser Kontaktposition stoffschlüssig miteinander verbunden werden.

12. Verfahren nach Anspruch 11, **dadurch gekennzeichnet, dass** in der Kontaktposition ein Körper (4) entlang der Längsachse (AA') derart über die Ableitungsanordnung (3) geschoben wird; dass ein erstes Ende des Körpers (4) mit der Aufnehmeranordnung (2) mechanisch verbunden wird; und dass ein zweites Ende des Körpers (4) mit der Ableitungsanordnung (3) mechanisch verbunden wird.

13. Verfahren nach einem der Ansprüche 11 oder 12, **dadurch gekennzeichnet, dass** die Ableitungsanordnung (3) und die Aufnehmeranordnung (2) in der Kontaktposition derart im Körper (4) angeordnet werden, dass die stoffschlüssige Verbindung zwischen Elektrodenstreifen (252) und Ladungsableitung (311) die einzige direkte mechanische und elektrische Verbindung zwischen Ableitungsanordnung (3) und Aufnehmeranordnung (2) ist.

## Claims

1. A piezoelectric pressure sensor (1); comprising a body (4) that protects the components of the pressure sensor (1) from shocks, impacts, dust, humidity; comprising a membrane (21) for capturing a force; comprising a piezoelectric transducer (22) on which the captured force generates electric polarization charges; comprising an electrode (25) that receives generated electric polarization charges and transmits them via a charge transmission (311) of a transmission arrangement (3); said electrode (25) comprises a charge pick-off (251) and at least one electrode strip (252); said charge pick-off (251) is arranged parallel to a front face (2231) of the piezoelectric transducer (22) where the force is applied onto said front face (2231); **characterized in that** the pressure sensor (1) comprises an anti-strain sleeve (231) that prevents, that mechanical strains from an attachment of the pressure sensor (1) to be transferred to components within pressure sensor (1); that the anti-strain sleeve (231) is mechanically connected to the membrane (21); that the electrode strip (252) protrudes through an electrode opening (2311) of the anti-strain sleeve (231); that an inner diameter of the body (4) is larger than/equal to an outer diameter of the transmission arrangement (3) so that the body (4) is slidable along a longitudinal axis (AA') over the transmission arrangement (3) to be positioned in a contact position, that in this contact position the body (4) is mechanically connected to the anti-strain sleeve (231), and that in this contact position the body (4) is mechanically connected to the transmission arrangement (3); and that the electrode strip (252) is connected to the charge transmission (311) by means of material bonding in certain areas; and that and the material bond between the electrode strip (252) and the charge transmission (311) forms the only direct mechanical and electrical connection between the transmission arrangement (3) and the transducer arrangement (2), whereby the transducer arrangement (2) comprises the membrane (21) the piezoelectric transducer (22) and the anti-strain sleeve (231).

2. The piezoelectric pressure sensor (1) according to claim 1 **characterized in that** the charge pick-off (251) and the electrode strip (252) are essentially disposed in an electrode plane (BC); or that the charge pick-off (251) and the electrode strip (252) are essentially disposed in an electrode plane (BC) that is arranged parallel to the front face (2231) of the piezoelectric transducer (22).

3. The piezoelectric pressure sensor (1) according to any of the claims 1 or 2, **characterized in that** the electrode (25) is foil-like in design and that the electrode (25) has a thickness of less than/equal to 200 µm, preferably less than/equal to 20 µm.

4. The piezoelectric pressure sensor (1) according to any of the claims 1 to 3, **characterized in that** the electrode strip (251) is connected to the charge pick-off (311) essentially free of mechanical stresses.

5. The piezoelectric pressure sensor (1) according to claim 1, **characterized in that** the electrode strip 252 comprises a contact surface at its outer end (2522); and that the contact surface of the electrode strip (252) is accessible from outside the anti-strain sleeve (231).

6. The piezoelectric pressure sensor (1) according to any of the claims 1 to 2, **characterized in that** a plurality of electrode strips (251) are connected to the charge pick-off (311) by material bonding and redundantly transmit electric polarization charges to the charge pick-off (311) .

7. A process of manufacturing a piezoelectric pressure sensor (1) according to any of the claims 1 to 6, **characterized in that** the anti-strain sleeve (231) is positioned by sliding it over the piezoelectric transducer (22) along a longitudinal axis (AA') and the electrode strip (252) protrudes in an angle to the longitudinal axis (AA') through an electrode opening (2311) of the anti-strain sleeve (231).

8. The process according to claim 7, **characterized in that** during sliding over the anti-strain sleeve (231) the electrode strip (252) is deflected out of an electrode plane (BC) by a wall of the anti-strain sleeve (231); and that the electrode strip (252) after sliding over the anti-strain sleeve (231) protrudes through the electrode opening (2311) of the anti-strain sleeve (231) and essentially returns into the electrode plane (BC).

9. The process according to any of the claims 7 or 8, **characterized in that** the membrane (21) comprises a membrane element (211), a central pretensioning element (212), and a pretensioning body (213), an end of the central pretensioning element (212) facing away from the membrane element (211) is mechanically connected to the pretensioning body (213); the piezoelectric transducer (22) is arranged between the membrane element (211) and the pretensioning body (213) with respect to the longitudinal axis (AA'); the piezoelectric transducer (22) is supported by the central pretensioning element (212); that a first end of the anti-strain sleeve (231) is mechanically connected to the membrane element (211); and that a second end of the anti-strain sleeve (231) is mechanically connected to the pretensioning body (213) whereby a transducer arrangement (2) is formed.

10. The process according to claim 9, **characterized in that** the charge pick-off (311) and an electric plug connection (341) are electrically and mechanically connected to each other; that the charge pick-off (311) and the electric plug connection (341) are accommodated in a transmission body (331), and the charge pick-off (311) transmits electric polarization charges to the electric plug connection (341) whereby a transmission arrangement (3) is formed.

11. The process according to claim 10, **characterized in that** the transmission arrangement (3) and the transducer arrangement (2) are positioned in a contact position with respect to one another so that the charge pick-off (311) makes mechanical contact to the electrode strip (252) protruding from the electrode opening (2311); and that the electrode strip (252) and the charge pick-off (311) are connected to each other in this contact position by material bonding.

12. The process according to claim 11, **characterized in that** in the contact position a body (4) is positioned on top of the transmission arrangement (3) by sliding along the longitudinal axis (AA'); that a first end of the body (4) is mechanically connected to the transducer arrangement (2); and that a second end of the body (4) is mechanically connected to the transmission arrangement (3).

13. The process according to any of the claims 11 or 12, **characterized in that** in the contact position the transmission arrangement (3) and the transducer arrangement (2) are arranged in the body (4) so that the connection by material bonding between the electrode strip (252) and the charge pick-off (311) is the only direct mechanical and electrical connection between the transmission arrangement (3) and the transducer arrangement (2).

## Revendications

1. Capteur de pression piézoélectrique (1) comprenant un corps (4) qui protège les composants du capteur de pression (1) contre les chocs, les impacts, la poussière, l'humidité; comprenant une membrane (21) qui détecte une force; comprenant un transducteur piézoélectrique (22) sur lequel la force détectée génère des charges de polarisation électriques; comprenant une électrode (25) qui reçoit les charges de polarisation électriques générées et les transmit via un dispositif de transmission de charges (311) d'un agencement de transmission (3); laquelle électrode (25) comprenant une prise de charge (251) et au moins une bande d'électrode (252); ladite prise de charge (251) étant disposée parallèlement à une face d'extrémité (2231) du transducteur piézoélectrique (22), sur laquelle face d'extrémité (2231) agit la force; **caractérisé en ce que** le capteur de pression (1) comprend une douille anti-strain (231) qui empêche la transmission des tensions mécaniques d'une fixation du capteur de pression (1) aux composants à l'intérieur du capteur de pression (1); **en ce que** ladite douille anti-strain (231) est reliée mécaniquement à la membrane; **en ce que** la bande d'électrode (252) dépasse à travers une ouverture d'électrode (2311) de la douille anti-strain (231); **en ce qu'**un diamètre intérieur du corps (4) est supérieur ou égal à un diamètre extérieur de l'agencement de transmission (3) de sorte que le corps (4) peut être coulissé le long d'un axe longitudinal (AA') sur l'agencement de transmission (3) dans une position de contact; **en ce que** dans cette position de contact le corps (4) est relié mécaniquement à la douille anti-strain (231), et **en ce que** dans cette position de contact le corps (4) est relié mécaniquement à l'agencement de transmission (3); et **en ce que** la bande d'électrode (252) est connectée au dispositif de transmission de charges (311) par liaison de matière au moins dans certaines zones; et **en ce que** ladite liaison de matière entre la bande d'électrode (252) et le dispositif de transmission de charges (311) est la seule connexion mécanique et électrique directe entre l'agencement de transmission (3) et l'agencement de capteur (2); dans lequel l'agencement de capteur (2) comprend la membrane (21), le transducteur piézoélectrique (22) et la douille anti-strain (231).

2. Capteur de pression piézoélectrique (1) selon la revendication 1, **caractérisé en ce que** la prise de charge (251) et la bande d'électrode (252) sont disposées sensiblement dans un plan d'électrode (BC), lequel plan d'électrode (BC) s'étendant en parallèle à la face d'extrémité (2231) du transducteur piézoélectrique (22).

3. Capteur de pression piézoélectrique (1) selon l'une quelconque des revendications 1 ou 2, **caractérisé en ce que** l'électrode (25) est en forme de feuille; et **en ce que** l'électrode (25) a une épaisseur inférieure/égale à 200 µm, de préférence inférieure/égale à 20 µm.

4. Capteur de pression piézoélectrique (1) selon l'une quelconque des revendications 1 à 3, **caractérisé en ce que** la bande d'électrode (251) est reliée mécaniquement au dispositif de transmission de charges (311) sensiblement sans tension.

5. Capteur de pression piézoélectrique (1) selon la revendication 1, **caractérisé en ce que** la bande d'électrode 252 présente une surface de contact à une extrémité externe (2522); et **en ce que** la surface de contact de la bande d'électrode (252) est accessible depuis l'extérieur de la douille anti-strain (231).

6. Capteur de pression piézoélectrique (1) selon l'une quelconque des revendications 1 à 5, **caractérisé en ce que** une pluralité des bandes d'électrode (251) sont connectées par des liaisons de matière au dispositif de transmission de charges (311) et transmettent les charges de polarisation électriques de manière redondante au dispositif de transmission de charges (311).

7. Procédé de fabrication d'un capteur de pression piézoélectrique (1) selon l'une quelconque des revendications 1 à 6, **caractérisé en ce que** la douille anti-strain (231) est coulissée sur le transducteur piézoélectrique (22) selon un axe longitudinal (AA') et la bande d'électrode (252) fait saillie, obliquement par rapport à l'axe longitudinal (AA'), à travers une ouverture d'électrode (2311) de la douille anti-strain (231) .

8. Procédé selon la revendication 7, **caractérisé en ce que** lors du coulissement de la douille anti-strain (231) la bande d'électrode (252) est déviée hors d'un plan d'électrode (BC) par une paroi de la douille anti-strain (231); et **en ce que** après le coulissement de la douille anti-strain (231) la bande d'électrode (252) fait saillie à travers l'ouverture d'électrode (2311) de la douille anti-strain (231) et s'arrange à nouveau sensiblement dans le plan d'électrode (BC).

9. Procédé selon l'une quelconque des revendications 7 ou 8, **caractérisé en ce que** la membrane (21) comprend un élément de membrane (211), un élément central de prétension (212) et un corps de prétension (213), une extrémité de l'élément central de prétension (212) opposée à l'élément de membrane (211) est reliée mécaniquement au corps de prétension (213); **en ce que** le transducteur piézoélectrique (22) est disposé par rapport à l'axe longitudinal (AA') entre l'élément de membrane (211) et le corps de prétension (213); **en ce que** le transducteur piézoélectrique (22) est supporté par l'élément central de prétension (212); **en ce qu'**une première extrémité de la douille anti-strain (231) est connectée mécaniquement à l'élément de membrane (211); et **en ce qu'**une seconde extrémité de la douille anti-strain (231) est connectée mécaniquement au corps de prétension (213), formant ainsi un agencement de capteur (2).

10. Procédé selon la revendication 9, **caractérisé en ce que** le dispositif de transmission de charges (311) et un connecteur électrique (341) sont connectés l'un à l'autre électriquement et mécaniquement; **en ce que** le dispositif de transmission de charges (311) et le connecteur électrique (341) sont disposés dans un corps de transmission (331) et le dispositif de transmission de charges (311) transmit des charges de polarisation électriques au connecteur électrique (341), formant ainsi un agencement de transmission (3).

11. Procédé selon la revendication 10, **caractérisé en ce que** l'agencement de transmission (3) et l'agencement de capteur (2) sont positionnés l'un par rapport à l'autre dans une position de contact de sorte que le dispositif de transmission de charges (311) soit en contact mécanique avec la bande d'électrode (252) dépassant de l'ouverture d'électrode (2311); et **en ce que** la bande d'électrode (252) et le dispositif de transmission de charges (311) sont connectés l'un à l'autre par liaison de matière dans cette position de contact.

12. Procédé selon la revendication 11, **caractérisé en ce que** dans la position de contact, un corps (4) est coulissé le long de l'axe longitudinal (AA') sur l'agencement de transmission (3) de sorte qu'une première extrémité du corps (4) est connectée mécaniquement à l'agencement de capteur (2); et qu'une seconde extrémité du corps (4) est connectée mécaniquement à l'agencement de transmission (3) .

13. Procédé selon l'une quelconque des revendications 11 ou 12, **caractérisé en ce que** l'agencement de transmission (3) et l'agencement de capteur (2) sont disposés dans le corps (4) dans la position de contact de sorte que la liaison de matière entre les bandes d'électrode (252) et le dispositif de transmission de charges (311) est la seule connexion mécanique et électrique directe entre l'agencement de transmission (3) et l'agencement de capteur (2).
